# EUROPEAN PATENT APPLICATION

(11) **EP 1 276 167 A1**
(43) Date of publication of application: **15.01.2003**
(21) Application number: 02023470.4
(22) Date of filing: 22.01.1997
(51) Int. Cl.: H01P 1/203, H01P 7/08, H03B 9/14

(54) **Variable-frequency resonator, variable-frequency oscillator, and variable-frequency filter**

(30) Priority: 25.01.1996 JP 1080896
(62) Divisional of application: 97100951.9
(71) Applicant: Murata Manufacturing Co., Ltd., Nagaokakyo-shi Kyoto-fu 617-8555 (JP)
(72) Inventor: Ishikawa, Yohei, c/o (A170) Intel. Prop. Dpt., Nagaokakyo-shi 617-8555 (JP); Sakamoto, Koichi, c/o (A170) Intel. Prop. Dpt., Nagaokakyo-shi 617-8555 (JP); Yamashita, Sadao, c/o (A170) Intel. Prop. Dpt., Nagaokakyo-shi 617-8555 (JP)
(74) Representative: Schoppe, Fritz, Dipl.-Ing.

(57) **Abstract**

A variable-frequency resonator has a dielectric strip serving as a main line (1;14) and a dielectric strip serving as a sub line (2;15). A dielectric resonator (3) is disposed therebetween, and a diode board (16) is disposed at an intermediate point of the dielectric strip serving as the sub line (2;15). The electrical length of the sub line (2;15) is switched according to the electrically conductive/open state of the diode (7). With this switching, the resonant frequency of the dielectric resonator is changed. Therefore, a variable-frequency resonator having a high Q value, a variable-frequency oscillator having a high C/N ratio, and a variable-frequency filter having low loss are implemented.

## Description

### BACKGROUND OF THE INVENTION

### 1. Field of the Invention

The present invention relates to variable-frequency resonators, variable-frequency oscillators, and variable-frequency filters used in microwave- and millimeter-wave-frequency communications.

### 2. Description of the Related Art

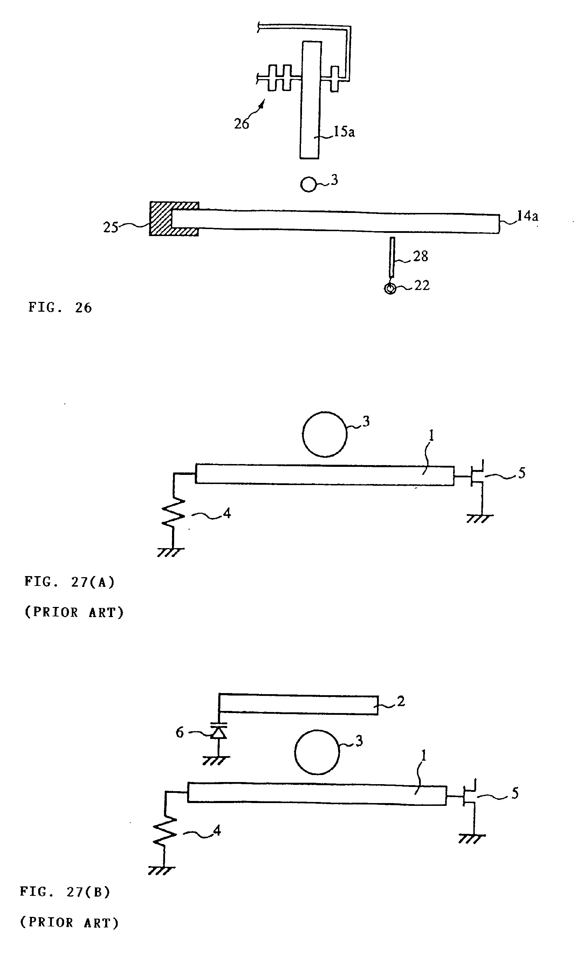

Dielectric resonators have many features such as high Q values, low dependance of the resonant frequency on temperature, and the advantage of being made compact at low cost. Hollow resonators and stripline resonators, which have been used in various fields for a long period, have recently been gradually replaced with dielectric resonators. In an oscillator employing a conventional dielectric resonator 3, shown in Fig. 27A, a microstripline 1 is disposed in the vicinity of the dielectric resonator 3. A terminating resistor 4 and a field effect transistor (FET) 5 are connected to the ends of the microstripline 1. A part of a signal input through the FET 5 is reflected near the coupling point between the dielectric resonator 3 and the microstripline 1 and amplified by the negative resistance of the FET 5. As a result, the FET 5 outputs an oscillating signal. This is due to the generation of injection locking. In other words, in the signal input through the FET 5, only a component having the same frequency as the resonant frequency of the dielectric resonator 3 is reflected near the coupling point and returned to the FET 5.

Therefore, the stability of the oscillation frequency with respect to temperature of the oscillator depends on the resonant frequency of the dielectric resonator 3. As described above, since the resonant frequency of the dielectric resonator 3 slightly depends on temperature, the oscillator has a highly stable oscillation frequency with respect to temperature. Since the dielectric resonator has a high Q value, a good C/N ratio is obtained.

To use an oscillator with the dielectric resonator and the microstripline as a frequency-modulation (FM) oscillator, the oscillation frequency needs to be variable. To this end, a microstripline 2 serving as a sub line is provided close to the dielectric resonator 3 in addition to the microstripline 1 serving as the main line, as shown in Fig. 27B. Moreover, a variable-reactance device 6 such as a varactor diode is connected to an end of the microstripline 2. Due to changes in voltage applied to the variable-reactance device, the resonant frequency of the dielectric resonator 3 changes, and as a result, the frequency of the oscillating signal changes.

To make the resonant frequency of the dielectric resonator variable by using the microstripline and the reactance device, as described above, the dielectric resonator 3 needs to be disposed near the microstripline 2 so as to be coupled with the microstripline 2. Since a part of the resonant current flowing through the dielectric resonator 3 also flows into the metallic microstripline 2, and the reactance device 6 such as a varactor diode has a low Q value, the Q value of the dielectric resonator is reduced. Therefore, the C/N ratio becomes lower than that of the fixed-frequency oscillator shown in Fig. 27A.

Since the reactance device 6 used for microwave and millimeter-wave frequencies generally has a small capacitance, with a stray capacitance added when the resonator is mounted on a circuit board, the effective capacitance change rate lowers and the variable-frequency range is narrowed. It is expected that this problem also occurs in a variable-frequency resonator and a variable-frequency filter having the configuration shown in Fig. 27B. Therefore, the variable-frequency resonator has a reduced Q value. The variable-frequency filter has an increased insertion loss.

JP 05263465A discloses a dielectric resonator circuit comprising a dielectric substrate, a grounding conductor arranged on one face of substrate and, arranged on the opposite face of the substrate, a microstrip line, a dielectric resonator and a plurality of line patterns. The resonance frequency is adjusted by sucessively connecting the line patterns by metal foils.

JP 62303201 describes a voltage controlled oscillator for controlling a dielectric resonator. According to this document, the differentiation characteristic is easily adjusted by a provision of an oscillation transistor and a resistor board adhered onto the emitter bias line of the oscillation transistor.

EP 0520641A1 describes a dielectric resonator configuration implementing a resonator arrangement. In particular, an adjustable dielectric resonator comprising a rectangular dielectric block having a hole extending from the upper face to the lower face of the block is disclosed. All faces except the side face and at least a part of the upper face around the hole of the dielectric block are coated with an electrically conductive material being coupled to ground. The non-coated side face is provided with a conductive pattern including an L-shaped strip and a horizontal conductive strip thereby forming a first resonator where conductive area serves as a capacitive load. Another resonator is formed of another conductive strip on the non-coated side face. A variation of such a resonator is shown which deviates from the above embodiment in that the second resonator is formed by a strip line and, additionally, a conductive strip wherein a switching element is connected therebetween in order to either connect strip line to ground or to connect strip line to conductive strip. By this measure, the effective resonator frequency of the main resonator can be set to two different values

Accordingly, it is an object of the present invention to provide a variable-frequency resonator having a high Q value, a variable-frequency oscillator having a high C/N ratio, and a variable-frequency filter having a low insertion loss.

This object is achieved by a variable-frequency resonator according to claim 1, a variable-frequency oscillator according to claim 5, and a variable-frequency filter according to claim 6.

The foregoing object is achieved according to the present invention through the provision of a variable-frequency resonator including a main line; a sub line which is not directly coupled with the main line; and a dielectric resonator coupled with the main line and the sub line. In order to suppress a reduction in Q value of the dielectric resonator due to the sub line, the resonator also includes a switching device disposed at an intermediate position in the sub line. The electrical length of the sub line changes according to an electrically conductive/open state of the switching device, and the resonant frequency of the dielectric resonator changes. The switching device is not used for changing its reactance like a conventional varactor diode but for just switching between the electrically conductive state and the open state. As such a switching device, a device having a high Q value such as a pin diode, for example, can be used. A reduction in Q value of the dielectric resonator can be suppressed.

In the variable-frequency resonator, the main line and the sub line may be microstriplines. The switching device may be connected between an intermediate point of the sub line and the ground, or between the sub line divided into two portions.

The main line and the sub line may be non-radiative dielectric lines.

The main line and the sub line may be made up of non-radiative dielectric lines in which a dielectric strip and a circuit board are disposed between parallel electrically conductive plates.

When non-radiative dielectric lines are used, since the electrical length of the sub line coupled with the dielectric resonator is switched according to an electrically conductive/open state of the switching device, the resonant frequency of the dielectric resonator is switched and a variable-frequency resonator is implemented. Unlike a case in which microstriplines are used, since a part of the resonant current of the dielectric resonator does not flow into the sub line, even if the dielectric resonator is strongly coupled with the non-radiative dielectric lines, the dielectric resonator has almost no reduction in Q value, and a variable-frequency resonator having a extremely high Q value is implemented.

According to the present invention, a variable-frequency oscillator and a variable-frequency filter having the same configuration as described above can be made. This means that a variable-frequency oscillator having a high C/N ratio and a variable-frequency filter having a low loss can be implemented.

Other features of the present invention will be made clear in the following description.

### BRIEF DESCRIPTION OF THE DRAWINGS

Fig. 1 is a plan of a variable-frequency resonator according to a first aspect of the present invention.
Fig. 2 is an equivalent circuit diagram of the resonator shown in Fig. 1.
Fig. 3 is a characteristic chart of the resonator shown in Fig. 1.
Fig. 4 is a plan of a variable-frequency resonator according to a second aspect of the present invention.
Fig. 5 is an equivalent circuit diagram of the resonator shown in Fig. 4.
Fig. 6 is a cross section of a variable-frequency resonator according to a third aspect of the present invention.
Fig. 7 is a partial perspective view of a variable-frequency filter according to a fourth aspect of the present invention.
Fig. 8 is a cross section of a main part of the variable-frequency filter.
Fig. 9 is a plan of the main part of the variable-frequency filter.
Fig. 10 shows a configuration of a diode board used in the variable-frequency filter.
Fig. 11 is an equivalent circuit diagram of the variable-frequency filter.
Fig. 12 is a plan of a main part of a variable-frequency filter according to a fifth aspect of the present invention.
Fig. 13 is a plan of a main part of a variable-frequency filter according to a sixth aspect of the present invention.
Fig. 14 is a characteristic chart of the variable-frequency filter.
Fig. 15 is a plan of a main part of a variable-frequency oscillator according to a seventh aspect of the present invention.
Fig. 16 is a cross section of the main part of the variable-frequency oscillator.
Fig. 17 is a plan showing a configuration of a circuit board of a variable-frequency oscillator according to an eighth aspect of the present invention.
Fig. 18 is a cross section of the variable-frequency oscillator.
Fig. 19 is a plan showing a configuration of a portion to which a pin diode is mounted.
Fig. 20 is a partial perspective view showing coupling between electrodes to which the pin diode is connected and non-radiative dielectric lines.
Fig. 21 is a plan showing a portion to which a pin diode is mounted in a variable-frequency resonator according to a ninth aspect of the present invention.
Fig. 22 is a plan showing a configuration of a circuit board in a variable-frequency oscillator according to a tenth aspect of the present invention.
Fig. 23 is a cross section of the variable-frequency oscillator.
Fig. 24 is a plan showing a configuration of a portion to which a gun diode is mounted in the variable-frequency oscillator.
Fig. 25 is a plan showing a configuration of a circuit board in a variable-frequency oscillator according to an eleventh aspect of the present invention.
Fig. 26 is a plan of a main part of a variable-frequency oscillator according to a twelfth aspect of the present invention.
Fig. 27A shows a configuration of a conventional fixed-frequency oscillator.
Fig. 27B shows a configuration of a conventional variable-frequency oscillator.

### DESCRIPTION OF THE PREFERRED EMBODIMENTS

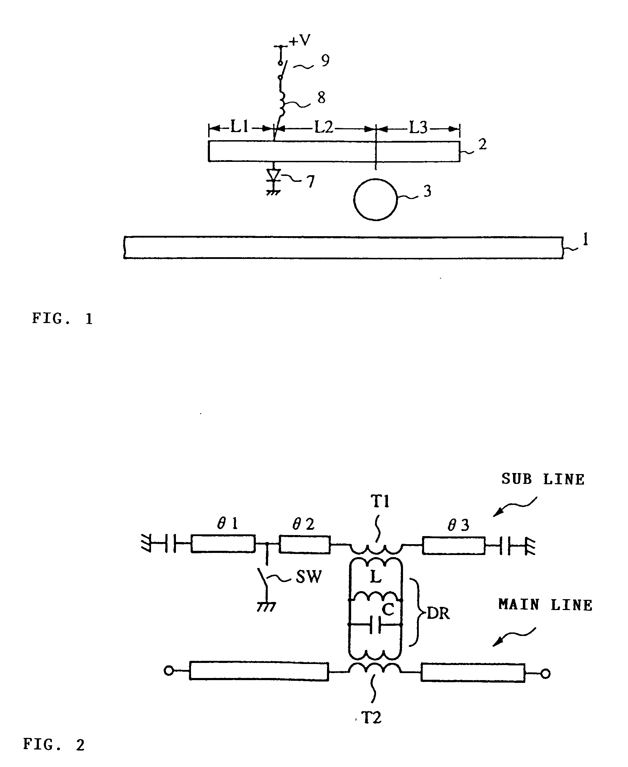

A configuration of a variable-frequency resonator according to an embodiment of the present invention will be described below by referring to Figs. 1 to 5.

In Fig. 1, there is disposed a microstripline 1 serving as a main line and a microstripline 2 serving as a sub line which is not directly coupled with the microstripline 1. A dielectric resonator 3 in the TE_{01δ} mode is disposed such that it is magnetically coupled with the microstriplines 1 and 2. Between an intermediate point of the microstripline 2 and the ground, a switching device 7 is connected. There is also provided a low-pass filter 8 and a switch 9 for connecting and disconnecting a bias voltage to the switching device 7. The switch 9 turns the switching device 7 on and off.

Fig. 2 is an equivalent circuit diagram of the resonator shown in Fig. 1. In Fig. 2, θ1, θ2, and θ3 indicate the electrical lengths of portions L1, L2, and L3 of the microstripline 2 shown in Fig. 1, respectively, and SW and DR correspond to the switching device 7 and the dielectric resonator 3. T1 and T2 are ideal transformers which form the magnetic coupling between the dielectric resonator 3 and the main and sub lines. Since the electrical length of the sub line which is coupled with the dielectric resonator DR changes according to the on/off state of the switching device, the resonant frequency of the dielectric resonator DR changes.

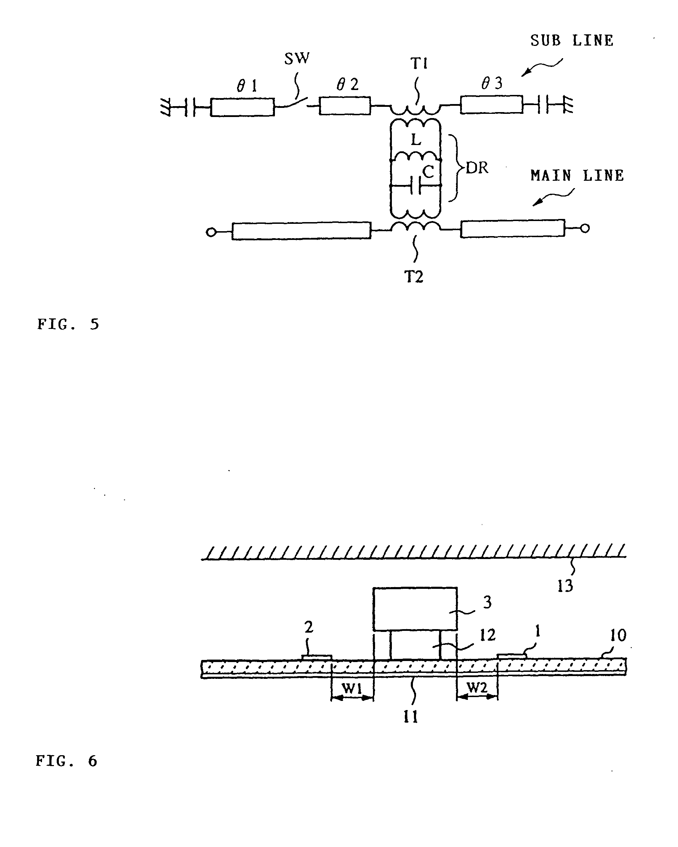

Fig. 6 is a cross section of a variable-frequency resonator. On the upper surface of a circuit board 10, a microstripline 1 serving as a main line and a microstripline 2 serving as a sub line are formed. On the lower surface of the circuit board 10, a ground conductor 11 is provided. Also on the upper surface of the circuit board 10, a cylindrical support base 12 having a low dielectric constant is mounted and then a cylindrical TE_{01δ} mode dielectric resonator 3 is mounted on it. The dielectric resonator 3 may have another shape as required. The microstriplines 1 and 2 are magnetically coupled with the dielectric resonator 3.

On the upper surface of the circuit board 10, a pin diode for connecting a specified point of the microstripline 2 to the ground conductor and a circuit for supplying a bias voltage to the diode are provided. The microstriplines 1 and 2, and the dielectric resonator 3 are disposed on the circuit board 10 as shown in Fig. 1. The circuit board 10 is surrounded by a shielding conductor 13 to form the variable-frequency resonator.

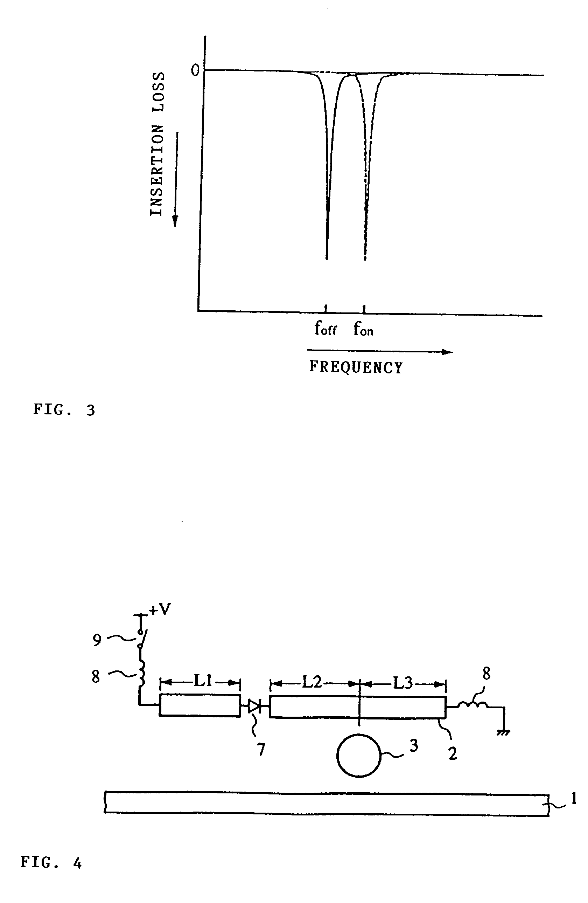

Fig. 3 indicates an insertion loss between the input and output sections of the main line shown in Fig. 2. The resonant frequency obtained when the switching device SW is open is named f_{off} and the resonant frequency obtained when the switching device SW is closed is named fₒₙ. When the switching device SW is open, a signal having the frequency f_{off} is attenuated. When the switching device is closed, a signal having the frequency fₒₙ is attenuated.

In the variable-frequency resonator, the distance between the dielectric resonator and the sub line, and the lengths of the portions of the sub line, L1, L2, and L3, are determined such that a required variable-frequency range is obtained. In the equivalent circuit shown in Fig. 2, the resonant frequency changes by 410 MHz by turning on/off the switching device SW when θ1 = θ2 = 40 degrees, θ3 = 90 degrees, Z₀ = 50 Ω, the coupling coefficient of T1 is 1:40, the coupling coefficient of T2 is 1:50, the inductance L of the dielectric resonator is 0.7 nH, the capacitance C of the dielectric resonator is 0.01 pF, the Q value of the dielectric resonator is 5000, and the resonant frequency is 60 GHz.

Fig. 4 is an equivalent circuit diagram of a variable-frequency resonator in which a switching device is inserted at an intermediate point of a sub line. When a switch 9 is closed, a bias voltage is applied to a switching device 7 to close it. When the switch 9 is opened, the switching device 7 opens.

Fig. 5 is an equivalent circuit diagram of the resonator shown in Fig. 4. Since the electrical length of the sub line which is coupled with the dielectric resonator DR changes according to the on/off state of the switching device, the resonant frequency of the dielectric resonator DR can be changed.

In the variable-frequency resonator shown in Fig. 6, when signal input and output sections are provided for the microstripline 1 serving as the main line, a component having the same frequency as the resonant frequency of the dielectric resonator 3 is trapped in the input signal. Therefore, a band elimination filter is implemented which can switch the trap frequency by switching the switching device.

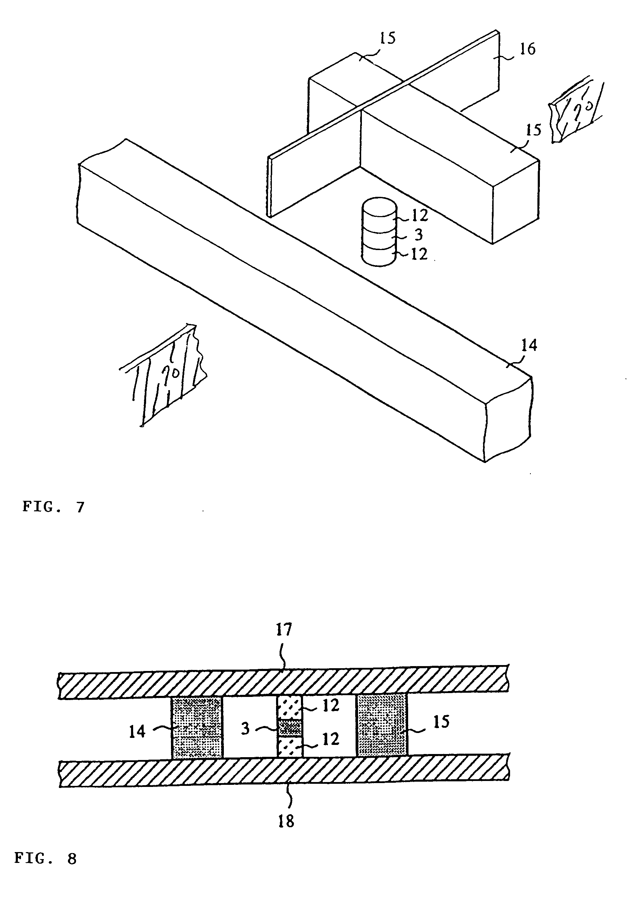

A configuration of a variable-frequency filter according to a second embodiment of the present invention will be described below by referring to Figs. 7 to 11.

Fig. 7 is a partial perspective view of the filter with an upper electrically conductive plate removed. There is provided a dielectric strip 14 serving as a main line and a dielectric strip 15 serving as a sub line in non-radiative dielectric lines. A diode board 16 described later is put in the dielectric strip 15 at an intermediate point. Between the two dielectric strips 14 and 15, a dielectric resonator 3 sandwiched by support bases 12 is provided.

Fig. 8 is a cross section of the filter taken on a plane 70 passing through the filter. Fig. 8 indicates a state in which the upper and lower electrically conductive plates 17 and 18 are mounted. The support bases 12 are made up of a low-dielectric-constant resin or ceramic. The support bases 12 are not necessarily mounted in the upper and lower directions of the dielectric resonator. Only one of them is needed if the dielectric resonator 3 is secured apart from the upper and lower dielectric plates.

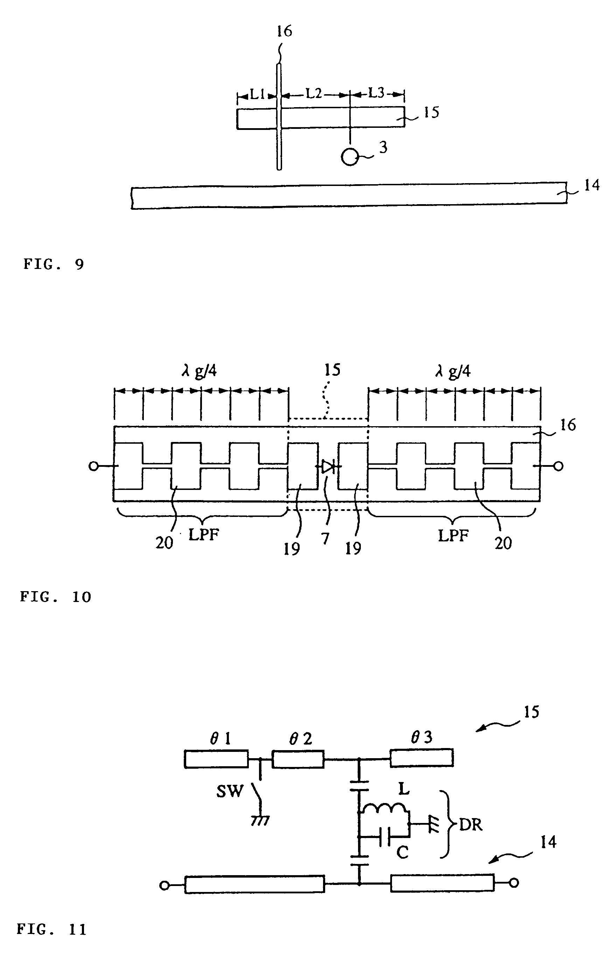

Fig. 9 is a plan of the filter. The distance between the dielectric resonator 3 and the dielectric stripline 15 serving as the sub line, and the lengths of the portions of the dielectric strip 15, L1, L2, and L3, are determined such that a required variable-frequency range is obtained.

Fig. 10 is a view showing a configuration of the diode board 16. Two electrodes 19 are provided at portions against which the dielectric strip 15 is butt when the filter is assembled. Between the electrodes, a pin diode 7 is mounted. When the pin diode is open, an LSM-mode signal which transfers in the non-radiative dielectric lines passes through the electrodes 19. When the pin diode is electrically conductive, the signal is reflected by the electrodes 19. The electrodes 19 are connected to conductive patterns 20 including portions having a low characteristic impedance and portions having a high characteristic impedance alternately at an interval of λ/4. The conductive patterns 20 serve as low-pass filters. Since a bias circuit for the pin diode is provided with the low-pass filters, coupling between the bias circuit and the dielectric strip 15 is avoided.

Fig. 11 is an equivalent circuit diagram of the variable-frequency filter. Since the dielectric resonator operates in the TE_{01δ} mode, the dielectric resonator is coupled with the dielectric strips 14 and 15. In the equivalent circuit, they are coupled by capacitors as shown in Fig. 11.

Since the electrical length of the non-radiative dielectric line made up of the dielectric strip 15 and the upper and lower electrically conductive plates changes according to the on/off state of the pin diode, the resonant frequency of the dielectric resonator changes. Therefore, when signal input and output sections are provided for the non-radiative dielectric line, a variable-frequency band elimination filter is implemented in the same way as shown in Fig. 3. In other words, the frequency of the signal component to be trapped by the dielectric resonator can be switched among the externally input signal components. A multi-stage, variable-frequency band elimination filter can be implemented by differentiating the electrical lengths to be switched of the dielectric strip serving as the sub line and by disposing a plurality of the pairs along the dielectric strip serving as the main line.

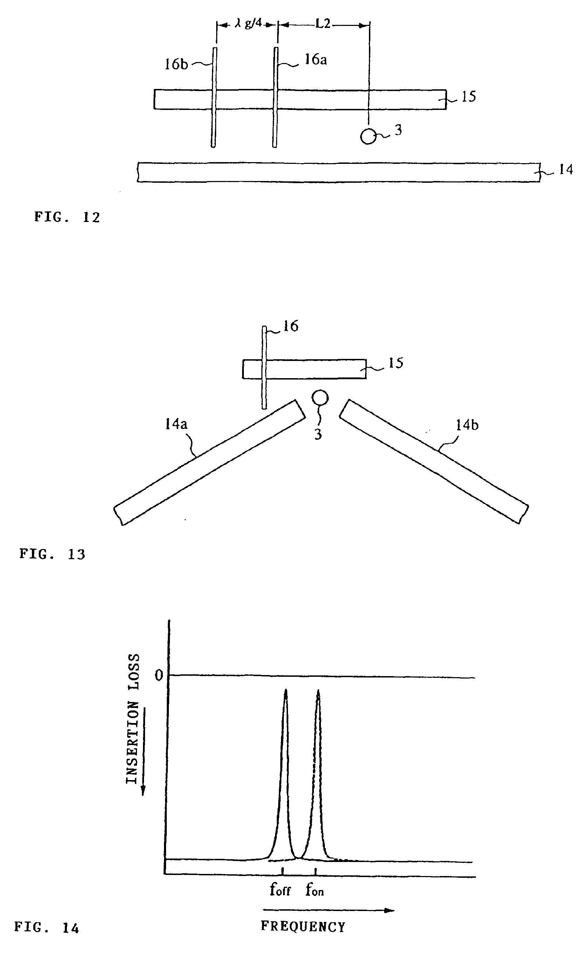

Fig. 12 shows a configuration of a variable-frequency filter according to a third embodiment of the present invention. In the second embodiment, the diode board is inserted at a point into the dielectric strip 15 serving as the sub line. When the pin diode is turned on, the electrodes 19 shown in Fig. 10 become conductive, and the position of the diode board becomes a short-circuit end of the dielectric strip 15. If line isolation is insufficient, a plurality of diode boards 16a and 16b are provided at an interval of λg/4 as shown in Fig. 12 and both diodes are switched on/off at the same time. With this configuration, the position away from the dielectric resonator 3 by L2 serves as an equivalent short-circuit position and the equivalent electrical length of the dielectric strip 15 serving as the sub line is positively switched.

Fig. 13 and Fig. 14 show a configuration and characteristic of a variable-frequency filter according to a fourth embodiment of the present invention. Fig. 13 illustrates a state in which the upper electrically conductive plate of the filter is removed. In this embodiment, two non-radiative dielectric lines, dielectric strips 14a and 14b (main lines), are disposed such that their ends are close to a dielectric resonator 3. To prevent direct coupling between these two dielectric strips 14a and 14b, and a dielectric strip 15, the end faces of the dielectric strips 14a and 14b are disposed as far as possible away from the end faces of the dielectric strip 15 and the strips are disposed at specified angles. The resonant frequency of the dielectric resonator 3 is switched by switching on/off a pin diode provided for a diode board 16. The insertion-loss characteristic of a signal passing through the two dielectric strips 14a and 14b coupled through the dielectric resonator 3 changes as shown in Fig. 14.

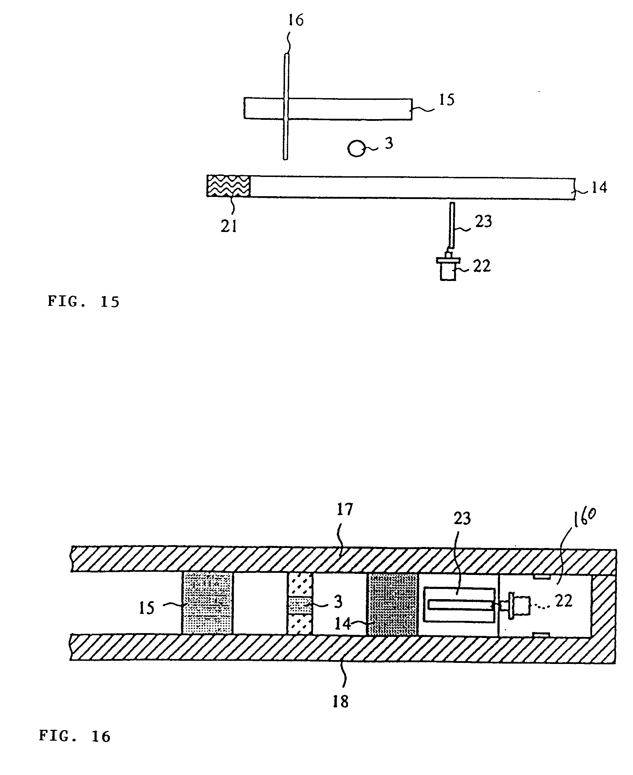

Fig. 15 and Fig. 16 show a configuration of a variable-frequency oscillator according to a fifth embodiment of the present invention. Fig. 15 illustrates a state in which the upper electrically conductive plate of the oscillator is removed. A diode board 16 is inserted at a specified position into a dielectric strip 15 which constitutes a non-radiative dielectric line serving as a sub line. At one end of a dielectric strip 14 which is a non-radiative dielectric line serving as a main line, a terminator 21 is provided. The terminator is formed by mixing a resistor member with a resin member which constitutes the dielectric strip 14. Between the dielectric strips 14 and 15, a dielectric resonator 3 is disposed. There is also shown a gun diode 22 and an excitation probe 23. The excitation probe 23 is disposed close to the dielectric strip 14 and perpendicular to the direction in which electromagnetic waves transfer in the dielectric strip 14.

Fig. 16 is a cross section of the variable-frequency oscillator. On the upper and lower surfaces of the dielectric strips 14 and 15, parallel electrically conductive plates 17 and 18 are disposed, and the dielectric resonator 3 is disposed between the two electrically conductive plates 17 and 18. The gun diode 22 is embedded in a fixed block 160. The excitation probe 23 is made up of an insulating board and an electrically conductive pattern provided thereon. The gun diode 22 is connected to the electrically conductive pattern with wire or ribbon.

The dielectric resonator 3, the dielectric strip 14, and the gun diode 22 form a band-reflective oscillator, and an LSM-mode electromagnetic wave is transferred to the dielectric strip 14. The oscillator selectively outputs a signal component having the same frequency as the resonant frequency of the dielectric resonator 3 among oscillating signal components generated by the gun diode 22. Therefore, since the dielectric resonator 3 has high frequency stability, the oscillation frequency of the oscillator is stable.

The gun diode itself usually has a frequency stability of about -100 ppm/□C with respect to temperature. Since the dielectric resonator 3 has a frequency stability of 5 ppm/□C or less with respect to temperature, the frequency stability of the oscillator with respect to temperature is maintained at 5 ppm/□C or less.

In this embodiment, the dielectric strip 15 is coupled with the dielectric resonator 3, and the resonant frequency of the dielectric resonator 3 is switched by switching on/off the pin diode on the diode board 16. With this switching, the oscillation frequency of the gun diode 22 is switched. Therefore, when a bias voltage applied to the pin diode on the diode board 16 is turned on/off according to a modulation signal, the oscillator serves as a frequency-shift-keying (FSK) oscillator.

Since the dielectric strips 14 and 15, and the diode board 16 have almost no loss, even if the dielectric resonator 3 is strongly coupled with the dielectric strips 14 and 15, the Q value has little reduction and a variable-frequency oscillator having a high C/N ratio is obtained.

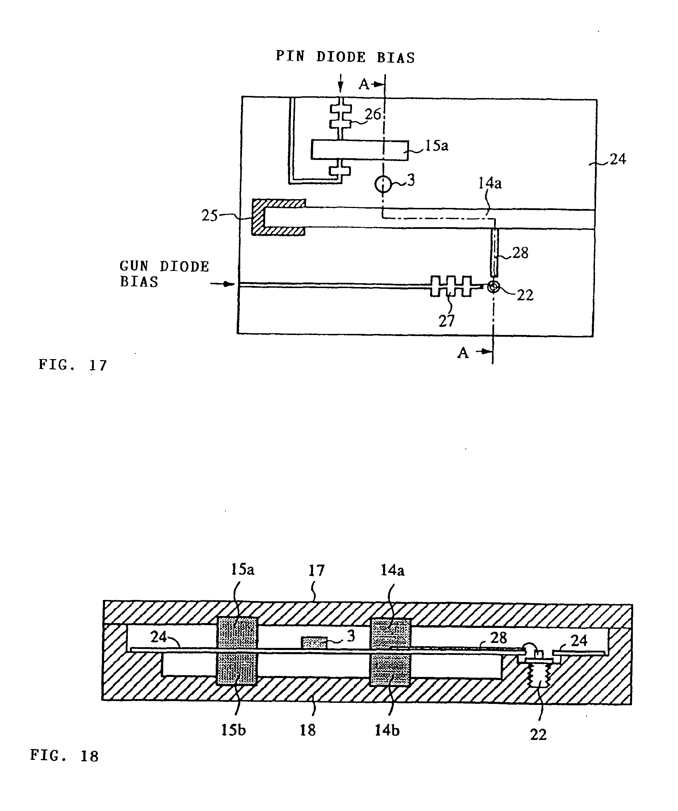

Figs. 17 to 20 show a configuration of a variable-frequency oscillator according to a sixth embodiment of the present invention. In the sixth embodiment, a main line and a sub line are formed in non-radiative dielectric lines in which dielectric strips and a circuit board are disposed between parallel electrically conductive plates.

Fig. 17 is a plan of the circuit board. Fig. 18 is a cross section taken from line A-A in Fig. 17 with the electrically conductive plates being disposed above and below the circuit board shown in Fig. 17.

An upper dielectric strip 14a is disposed on the upper surface of the circuit board 24, and a lower dielectric strip 14b is disposed on the lower surface of the circuit board 24. The ends of the dielectric strips 14a and 14b are terminated by resistor-member-film patterns 25.

At an intermediate point of a dielectric strip 15a serving as a sub line, a pin diode and electrodes are disposed as will be described later. The pin diode is connected to conductive patterns 26 for supplying a bias voltage. Another dielectric strip 15b is provided on the lower surface of the circuit board 24, which is located under the dielectric stripline 15a.

On the circuit board 24, a conductive pattern 27 for applying a bias voltage to a gun diode is provided. An electrode of the gun diode 22 is connected to the conductive pattern 27 with wire or ribbon. The circuit board 24 is also provided with an excitation conductive pattern 28. The excitation conductive pattern 28 is connected to the other electrode of the gun diode 22 with wire or ribbon. A cylindrical dielectric resonator 3 is secured on the circuit board 24 with adhesive. The dielectric resonator may have another shape as required.

Since the excitation conductive pattern 28 is disposed perpendicularly to the direction in which an electromagnetic wave proceeds in the dielectric strips 14a and 14b, the excitation conductive pattern 28 is coupled with an LSM-mode magnetic field within the non-radiative dielectric lines, and the oscillating signal generated by the gun diode transfers in the non-radiative dielectric lines 14a and 14b. The excitation conductive pattern 28 may be disposed such that a tip thereof is in the vicinity of the dielectric strip 14a without going inside the dielectric strip 14a.

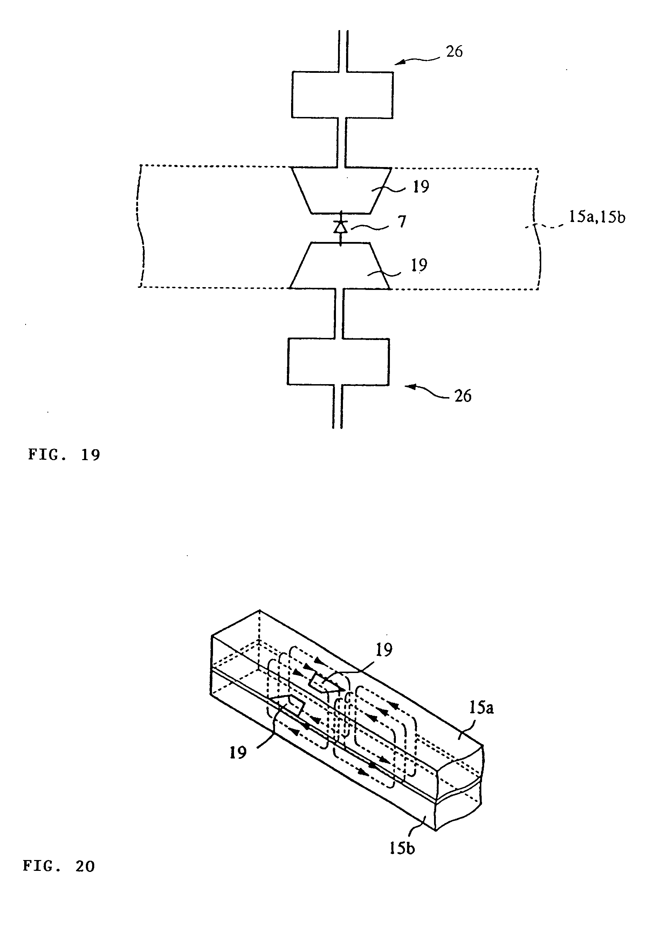

Fig. 19 is a partially enlarged view of the dielectric strips shown in Fig. 17. Two trapezoidal electrodes 19 are provided at a portion sandwiched by the dielectric strips 15a and 15b, and a pin diode 7 is mounted between the electrodes 19. When the pin diode 7 is open, the two electrodes 19 serve as slot lines. When the pin diode 7 is electrically conductive, the electrodes 19 are short-circuited and a signal transferring in the dielectric strips 15a and 15b is reflected at the position where the diode is disposed.

Fig. 20 shows coupling between an LSM-mode electromagnetic field and the electrodes 19 in the dielectric strips 15a and 15b. An electromagnetic field distribution in the slot lines is similar to that in the LSM mode in a non-radiative dielectric line. When the electrodes 19 are disposed in the direction in which a signal transfers in the dielectric strips 15a and 15b, the LSM-mode electromagnetic field is coupled with the electrodes 19.

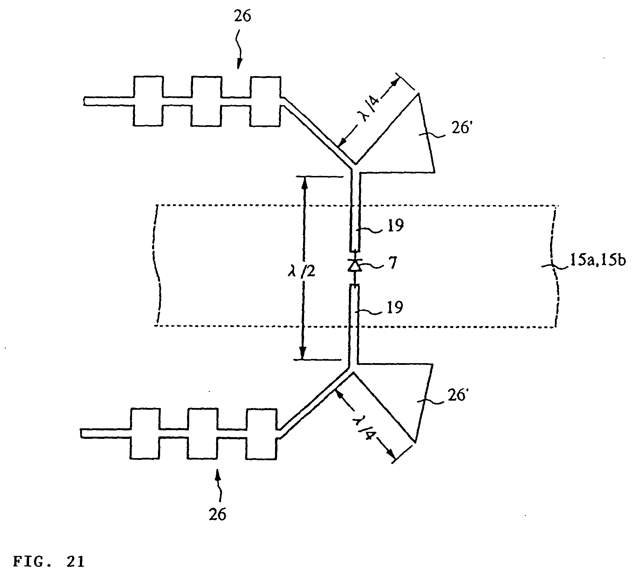

Fig. 21 shows conductive patterns for applying a bias voltage to a pin diode according to a seventh embodiment of the present invention. Electrodes 19 totaling λ/2 in length are disposed perpendicularly to dielectric strips 15a and 15b. The pin diode 7 is connected to the electrodes 19. Since a conductor λ/2 long is strongly coupled with an LSM-mode magnetic field, a signal transferring the dielectric strips 15a and 15b is reflected at the position of the electrodes 19 when the pin diode 7 is electrically conductive. The signal passes through the position of the electrodes 19 when the pin diode 7 is open. Provided are λ/4 open stubs 26' to equivalently short-circuit the roots of the electrodes 19. Since both ends of the electrodes totaling λ/2 in length are short-circuited, the middle becomes open. Therefore, a signal coupled with the non-radiative dielectric lines when the pin diode 7 is open does not go into the bias circuit for the pin diode. A signal does not come from the bias circuit, either.

As a conductor for applying a bias voltage to the pin diode 7, a suspended line or a coplanar guide may be used instead of the microstriplines shown in Fig. 21. When a grounding conductor on the circuit board needs to be connected to the upper and lower electrically conductive plates, the grounding conductor on the circuit board may be connected such that it butts against a pillar-shaped protrusion which is provided for the upper and lower electrically conductive plates at a position so as not to interfere with operations of components mounted on the circuit board or disposed between the upper and lower electrically conductive plates.

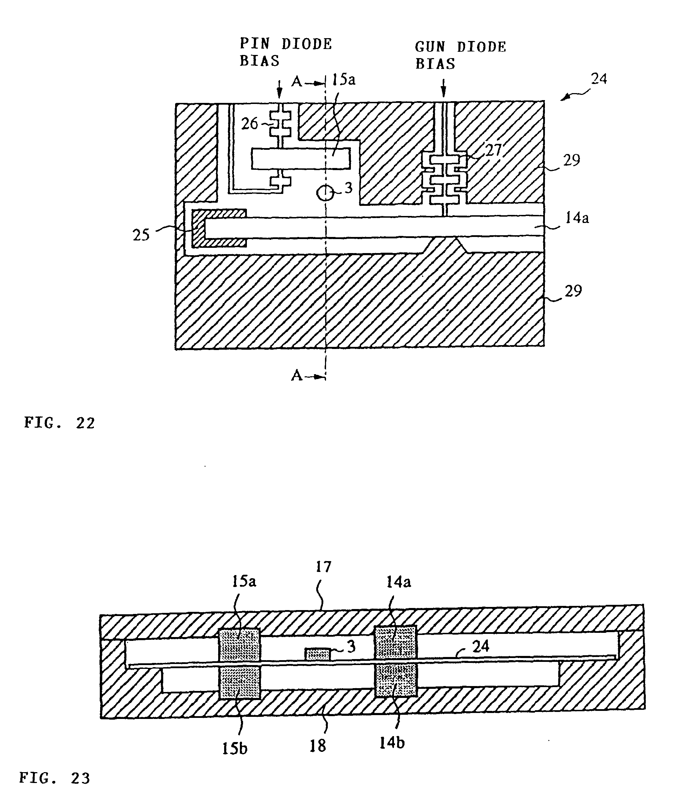

A configuration of a variable-frequency oscillator according to an eighth embodiment of the present invention will be described below by referring to Figs. 22 to 24. Fig. 22 is a plan of a main section of a circuit board. Fig. 23 is a cross section taken from line A-A in Fig. 22 with upper and lower electrically conductive plates being disposed above and below the circuit board. On the upper surface of the circuit board 24, conductive patterns 26 and 27 for applying bias voltages to a pin diode and a gun diode, respectively, a resistor film 25, and a ground conductor 29 are provided. An upper dielectric strip 14a serving as a main line, an upper dielectric strip 15a serving as a sub line, and a dielectric resonator 3 are also disposed on the upper surface of the circuit board 24. The gun diode is mounted such that it is sandwiched by the upper dielectric strip 14a and a lower dielectric strip 14b. In the same way, the pin diode is mounted such that it is sandwiched by the upper dielectric strip 15a and a lower dielectric strip 15b.

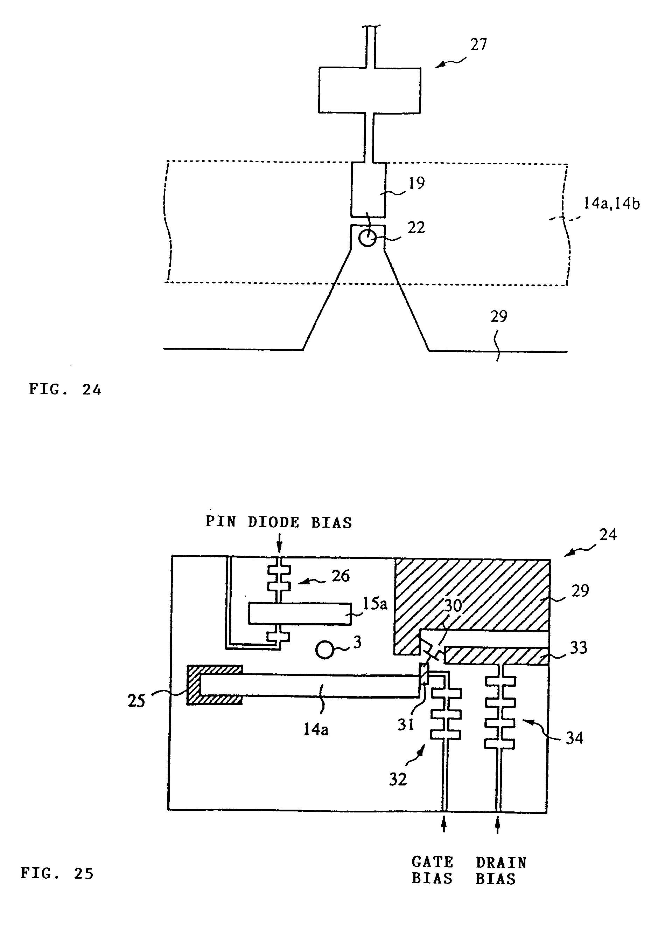

Fig. 24 is a partially enlarged view of Fig. 22. The ground conductor 29 extends toward the dielectric stripline 14a forming a protrusion. A so-called bare-chip gun diode 22 is mounted at the protrusion. One electrode of the gun diode 22 is connected to an electrode 19 with ribbon or wire. By using the bare-chip gun diode, the circuit board is made compact.

Fig. 25 shows a configuration of a circuit board of a variable-frequency oscillator according to a ninth embodiment of the present invention.

A gate coupling pattern 31, an output terminal 33, and a ground conductor 29 are provided on the circuit board at an end of a dielectric strip 14a. An FET 30 is connected to these conductors. There is also provided a conductive pattern 32 for supplying a gate bias voltage and a conductive pattern 34 for supplying a drain bias voltage. The rear surface of the circuit board around the FET is provided with a ground conductor so that the conductive patterns 32 and 34, and the output terminal 33 form a microstripline. The other configuration is the same as that shown in Fig. 17 or Fig. 22. An oscillating signal can be obtained from the microstripline by using the FET as a negative-resistance device. The FET may be gate-grounded or drain-grounded.

A bare-chip FET may be used. A bare-chip FET may be disposed between the dielectric strip 14a and the circuit board. In this case, a non-radiative dielectric line may be used as an output terminal.

Fig. 26 shows a plan of a main section of a variable-frequency oscillator according to a tenth embodiment of the present invention. On a circuit board, a conductive pattern 26 for applying a bias voltage to a pin diode, an excitation conductive pattern 28, and a resistor film 25 are provided. The conductive pattern 26 for supplying the bias voltage extends to the inside of a strip 15a, and its tip is connected to the pin diode. Another strip 15b is disposed on the rear surface of the circuit board below the strip 15a to form a non-radiative dielectric line.

An upper dielectric strip 14a serving as a main line is also disposed. On the rear surface of the circuit board, a lower dielectric strip 14b is disposed at the position opposite that of the strip 14a to form a non-radiative dielectric line. The dielectric strips 15a and 15b serving as the sub lines are disposed perpendicularly to the dielectric strips 14a and 14b serving as the main lines. A dielectric resonator 3 is disposed therebetween. An end of the dielectric strips 14a and 14b is terminated by the resistor film 25. A gun diode 22 is disposed below the circuit board. Through an opening of the circuit board, an electrode of the gun diode 22 is connected to an excitation conductive pattern 28 with ribbon or wire. With this configuration, namely, with a configuration in which the dielectric strips 15a and 15b serving the sub lines are disposed perpendicularly to the dielectric strips 14a and 14b serving as the main lines, with the dielectric resonator 3 disposed therebetween, the dielectric strips 14a and 14b are electrically coupled with the dielectric resonator 3, and the dielectric strips 15a and 15b are magnetically coupled with the dielectric resonator 3.

## Claims

1. A variable-frequency resonator comprising:
a main line (1;14);
a sub line (2;15) which is not directly coupled with said main line (1;14);
a dielectric resonator (3) coupled with said main line (1;14) and said sub line (2;15); and
an electronically switching device (7) disposed at an intermediate position in said sub line (2;15) for changing the electrical length of said sub line (2;15) according to an electrically conductive/open state of said electronically switching device (7),
**characterized in that** one end of said switching device (7) is connected to an intermediate point of said sub line (2), and the other end is connected to the ground.

2. A variable-frequency resonator according to Claim 1, wherein said main line (1) and sub line (2) are microstriplines.

3. A variable-frequency resonator according to Claim 1 or 2, further comprising:
a gap at an intermediate point of said sub line (2); and
a switching device (7) for connecting said sub line (2) divided by said gap.

4. A variable-frequency resonator according to Claim 1, wherein said main line (14) and said sub line (15) are non-radiative dielectric lines.

5. A variable-frequency resonator according to Claim 4, further comprising:
a first electrode disposed inside said sub line (15); and
a second electrode disposed inside said sub line (15) and insulated from said first electrode,
the electronically switching device (7) being adapted for connecting said first electrode and said second electrode.

6. A variable-frequency resonator according to Claim 4, wherein said main and sub line of non-radiative dielectric lines (14,15) comprise:
a circuit board (24);
a first dielectric strip (14a,15a) disposed on one main surface of said circuit board (24); and
a second dielectric strip (14b,15b) disposed on the other main surface of said circuit board (24) correspondingly to said first dielectric stripline.

7. A variable-frequency resonator according to Claim 5, further comprising:
a first electrode disposed inside said sub line (15); and
a second electrode disposed inside said sub line (15) and insulated from said first electrode,
wherein said electronically switching device (7) is adapted for connecting said first electrode and said second electrode.

8. A variable-frequency oscillator comprising:
a main line (14);
a sub line (15) which is not directly coupled with said main line (14);
a dielectric resonator (3) coupled with said main line (14) and said sub line (15);
an electronically switching device (7) disposed at an intermediate position in said sub line (15) for changing the electrical length of said sub line (15) according to an electrically conductive/open state of said electronically switching device (7); and
an oscillation circuit (22) coupled with said main line,
**characterized in that** one end of said switching device (7) is connected to an intermediate point of said sub line (2), and the other end is connected to the ground.

9. A variable-frequency filter comprising:
a main line (1;14);
a sub line (2;15) which is not directly coupled with said main line (1;14);
a dielectric resonator (3) coupled with said main line (1;14) and said sub line (2;15);
an electronically switching device (7) disposed at an intermediate position in said sub line (2;15) for changing the electrical length of said sub line (2;15) according to an electrically conductive/open state of said electronically switching device (7);
an input terminal connected to said main line (1;14); and
an output terminal connected to said main line (1;14),
**characterized in that** one end of said switching device (7) is connected to an intermediate point of said sub line (2), and the other end is connected to the ground.
